# EUROPEAN PATENT SPECIFICATION

(11) **EP 1 564 855 B1**
(45) Date of publication and mention of the grant of the patent: **19.10.2011**
(21) Application number: 05006792.5
(22) Date of filing: 06.02.1998
(51) Int. Cl.: H01S 5/183, H01S 5/42

(54) **Surface emitting laser devices and method of manufacture**
Oberflächenemittierende Laservorrichtung und Herstellungsverfahren
Dispositif laser à l'émission par la surface et méthode de fabrication

(30) Priority: 07.02.1997 US 37175 P; 30.09.1997 US 940867
(43) Date of publication of application: 17.08.2005
(62) Divisional of application: 98300875.6
(73) Proprietor: Xerox Corporation, Rochester, New York 14644 (US)
(72) Inventor: Thornton, Robert L., Los Altos, California 94022 (US)
(74) Representative: Grünecker, Kinkeldey, Stockmair & Schwanhäusser

(56) References cited:
- US-A- 5 493 577
- CHUA C L ET AL: "PLANAR LATERALLY OXIDIZED VERTICAL-CAVITY LASERS FOR LOW-THRESHOLD HIGH-DENSITY TOP-SURFACE-EMITTING ARRAYS" IEEE PHOTONICS TECHNOLOGY LETTERS,US,IEEE INC. NEW YORK, vol. 9, no. 8, 1 August 1997 (1997-08-01), pages 1060-1062, XP000699798 ISSN: 1041-1135
- HUFFAKER D L ET AL: "FABRICATION OF HIGH-PACKING-DENSITY VERTICAL CAVITY SURFACE- EMITTING LASER ARRAYS USING SELECTIVE OXIDATION" IEEE PHOTONICS TECHNOLOGY LETTERS,US,IEEE INC. NEW YORK, vol. 8, no. 5, 1 May 1996 (1996-05-01), pages 596-598, XP000589251 ISSN: 1041-1135
- EVANS P W ET AL: "EDGE-EMITTING QUANTUM WELL HETEROSTRUCTURE LASER DIODES WITH AUXILIARY NATIVE-OXIDE VERTICAL CAVITY CONFINEMENT" APPLIED PHYSICS LETTERS,US,AMERICAN INSTITUTE OF PHYSICS. NEW YORK, vol. 67, no. 21, 20 November 1995 (1995-11-20), pages 3168-3170, XP000544254 ISSN: 0003-6951

## Description

The present invention relates to surface emitting laser devices and to methods of manufacturing such devices.

Solid state semiconductor lasers are important devices in applications such as optoelectronic communication systems and high-speed printing systems. Recently, there has been an increased interest in vertical cavity surface emitting lasers ("VCSEL's") although edge emitting lasers are currently used in the vast majority of applications. A reason for the interest in VCSEL's is that edge emitting lasers produce a beam with a large angular divergence, making efficient collection of the emitted beam more difficult. Furthermore, edge emitting lasers cannot be tested until the wafer is cleaved into individual devices, the edges of which form the mirror facets of each device. On the other hand, not only does the beam of a VCSEL have a small angular divergence, a VCSEL emits light normal to the surface of the wafer. In addition, since VCSEL's incorporate the mirrors monolithically in their design, they allow for on-wafer testing and the fabrication of one-dimensional or two-dimensional laser arrays.

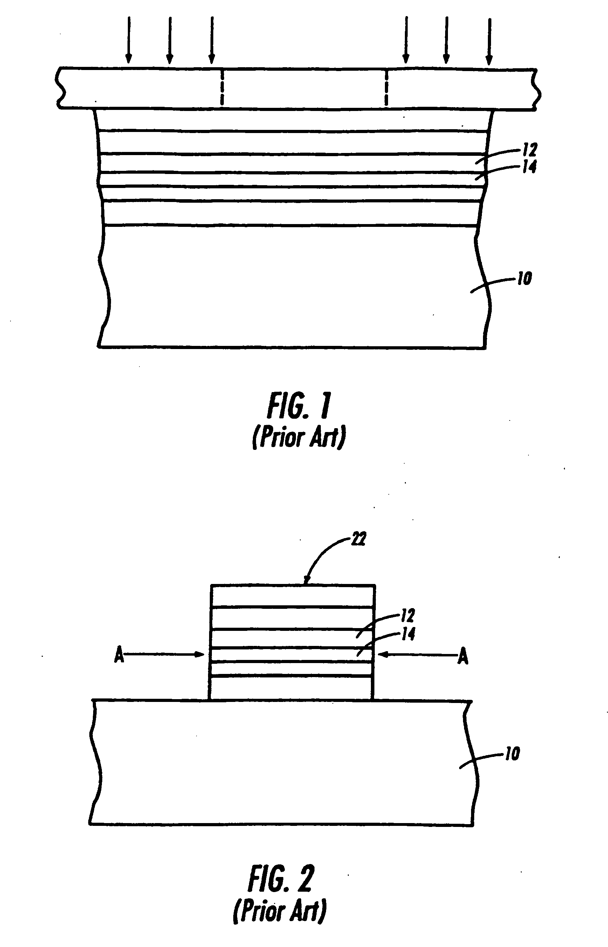

A known technique to fabricate VCSEL's is by a lateral oxidation process, as schematically illustrated in Figures 1 and 2. Under this approach, a laser structure comprising a plurality of layers is formed upon substrate 10. These layers include an active layer 12 and an AlGaAs layer 14 with a high aluminum content. The AlGaAs layer 14 is placed either above or below the active layer of a laser structure. Then, the layered structure is masked and selectively etched to form a mesa structure 22 as illustrated in Figure 2. As a result of the etching, the AlGaAs layer 14 with a high aluminum content adjacent to the active layer 12 is exposed at the edges of the mesa structure 22. To form the lasing emissive region or "aperture", this AlGaAs layer is oxidized laterally from the edges towards the center of the mesa structure as represented by arrows A. Other layers in the structure remain essentially unoxidized since their aluminum content is lower. Consequently, their oxidation rates are also substantially lower. Therefore, only the AlGaAs layer with high aluminum content is being oxidized. The oxidized portions of the high aluminum content layer become electrically non-conductive as a result of the oxidation process. The remaining unoxidized region, which is conductive, in the AlGaAs layer forms the so-called "aperture", a region which determines the current path in the laser structure, and thereby determines the region of laser emission. A VCSEL formed by such a technique is discussed in "Selectively Oxidized Vertical Cavity Surface Emitting Lasers With 50% Power Conversion Efficiency." Electronics Letters, vol. 31, pp.208-209 (1995). Other exemplary VCSEls are described in "Fabrication of high-packing-density vertical cavity surface- emitting laser arrays using selective oxidation", IEEE Photonics Technology Letters, vol. 8, nr 5, pp. 596-598 (1996).

The current lateral oxidation approach has several disadvantages, such as large mesa, large oxidation region, and poor control of the aperture size. A key disadvantage of this approach is the difficulty in controlling the amount of oxidation. Generally, the desired device aperture is on the order of one to ten microns (µm), which means that several tens of microns of lateral oxidation will typically be required in order to fabricate the device when oxidizing in from the sides of the much larger mesa, which must typically be 50 to 100 microns in size. Since the size of the resulting aperture is small relative to the extent of the lateral oxidation regions, the devices formed generally have severe variations in aperture size as a result of non-uniform oxidation rates from wafer to wafer and across a particular wafer. The oxidation rate of AlGaAs depends strongly on its aluminum composition. Any composition non-uniformity will be reflected by changes in the oxidation rate, which in turn creates uncertainty in the amount of oxidation. The process is also relatively temperature-sensitive. As the oxidation rate varies, it is difficult to ascertain the extent to which a laser structure will be oxidized, thereby decreasing reproducibility in device performance. In short, such a process often creates various manufacturability and yield problems.

Another disadvantage of a VCSEL formed by a traditional lateral oxidation approach is the difficulty it creates in forming high density laser arrays. In order to oxidize a buried layer of high aluminum content, an etching process is performed leaving a mesa. After the etching of this mesa, lateral oxidation is performed such that the oxidized regions define a laser aperture of a particular size. The use of a mesa structure, in part, limits the minimum spacing between two lasers in an array. The step height of the mesa is typically several microns because of the need to etch through a thick upper DBR mirror. Additionally, the top surface of the mesa also has to be relatively large so that a metal contact can be formed on it without covering the lasing aperture. Typically, the minimum size of an electrical contact is approximately 50 x 50 µm². Hence, the step height of the mesa and the placement of the electrical contact on the surface make it difficult to form highly compact or high density laser arrays.

A solution to some of the problems associated with a typical mesa structure is the use of a shallow mesa. In order to use a shallow mesa, the upper mirror is not formed by an epitaxial process. Instead, the upper mirror is formed by a deposited multilayer dielectric material, which reflects light. Electrical contact is made directly onto the upper portion of the active region. Devices formed under this approach have been fabricated on mesas with widths of approximately twelve microns. However, the added complexity of depositing a dielectric material and using a liftoff process to define the contact make it difficult to optimize the devices for low threshold current and high efficiency.

Lastly, a VCSEL formed by a traditional lateral oxidation approach often suffers from poor mechanical or structural integrity. It is well-known that the upward pressure applied during a packaging process may cause delamination of the entire mesa since the bonding of the oxide layer to the unoxidized GaAs or AlGaAs is generally weak.

In order to overcome the above drawbacks, a surface emitting laser is provided according to claim 1 and a method of producing the same according to claim 19.

In accordance with a further aspect of the present invention, there is provided an array of surface emitting lasers, each laser being as described in the claims.

The invention can be implemented in a highly compact VCSEL structure having well-defined and well-controlled oxidized regions, which can be used to define the lasing aperture of a laser structure. These oxidized regions can be formed by the use of a multiplicity of cavities arranged in a pre-defined pattern in the laser structure. The lasing aperture can be an unoxidized region bounded by these oxidized regions centered about the cavities. During the oxidation process, an AlGaAs layer with high aluminum content embedded in the semiconductor structure can be oxidized radially outwards from each of these cavities until the oxidized regions between two adjacent cavities overlap. The AlGaAs layer with high aluminum content for forming the oxidized regions and the aperture is often referred to as an "oxidation layer."

An advantage of the techniques described above is that the dimension of the oxidized regions which define the lasing aperture is comparable to the dimension of the lasing aperture itself. Generally, the oxidation rates of AlGaAs depend upon material composition and process parameters, which exhibit significant non-uniformity. These non-uniformities have decreasing impact as the ratio of the size of the oxidized regions to the size of the final laser aperture is reduced. In other words, since the amount of oxidation required to form the lasing aperture is dramatically reduced, the aperture size is therefore much less sensitive to material or process variations. Hence, well-defined and well-controlled apertures can be achieved.

Another advantage is that since the techniques do not require the formation of a relatively large and deep mesa structure, the distance between two lasers in an array is greatly reduced. Hence the techniques are particularly well-suited to the fabrication of highly compact lasers or high density laser arrays.

Yet another advantage is that even higher density laser arrays can be fabricated if a transparent conductor is used to form the electrical contact of the laser devices.

A further advantage is that the techniques result in highly planar laser structures which avoid using mesa structures with a steep step height. Such a planar technology improves the structural and mechanical stability of the devices and further simplifies the formation of electrical contacts to the devices.

The laser device can also include two reflectors, one on each side of the active layer and one of which allows partial transmission of light energy. The device can also include electrodes located on opposite sides of the device, enabling biasing of the active region. One electrode can be located on the emitting surface, overlying the aperture region. This electrode can be non-transparent with an opening through which light energy may be transmitted out of the device or it can be transparent, allowing partial transmission of light energy.

The invention will now be described, by way of example only, with reference to the accompanying drawings, in which:
FIGS. 1 and 2 illustrate a prior art approach to the formation of a laser aperture in a VCSEL structure;
FIG. 3 illustrates a side sectional view of a semiconductor structure;
FIG. 4 is a top view of a portion of a mask which may be applied to the semiconductor structure shown in FIG. 3;
FIG. 5 is a partial side sectional view of the semiconductor structure of FIG. 3 with a cavity etched therein;
FIG. 6 is a simplified top view of a portion of an oxidation layer, wherein the layers above it have been removed;
FIG. 7 is a cross-sectional view taken substantially along line 7-7 in FIG. 6 and in FIG. 9;
FIG. 8 is a cross-sectional view taken substantially along line 8-8 in FIG. 6 and in FIG. 9;
FIG. 9 is a top view of two adjacent VCSEL structures showing a non-transparent top contact;
FIG. 10 is a top view of two adjacent VCSEL structures showing a transparent top contact;
FIG. 11 shows a laser structure whose aperture is defined by a triangular bounding pattern of cavities;
FIG. 12 shows an array of lasers which is formed by repeating the triangular bounding pattern shown in FIG. 11;
FIG. 13 shows a laser structure whose aperture is defined by a bounding pattern of four cavities arranged in a square pattern;
FIG. 14 shows an array of lasers which is formed by repeating the square bounding pattern shown in FIG. 13;
FIG. 15 shows another array of lasers which is formed by repeating the square bounding pattern shown in FIG. 13;
FIG. 16 shows a laser structure whose aperture is defined by a bounding pattern of six cavities arranged in an hexagonal pattern;
FIG. 17 shows an array of lasers which is formed by repeating the hexagonal bounding pattern shown in FIG. 16; and
FIG. 18 shows another array of lasers which is formed by an alternative repeating of the hexagonal bounding pattern shown in FIG. 16.

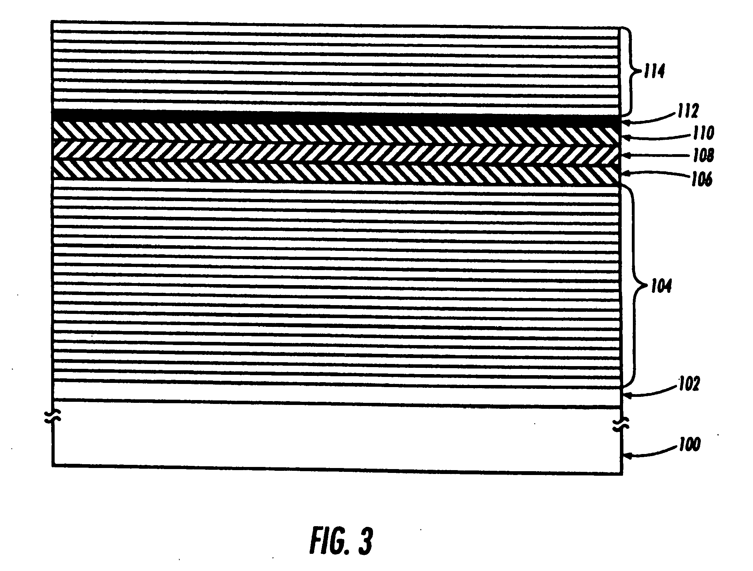

FIG. 3 illustrates a semiconductor structure with a number of semiconductor layers, which can be used to form a vertical cavity surface emitting laser. As will be apparent, the layers are illustrated schematically only and bear no relationship to the relative thicknesses each to the other. As shown in FIG. 3, an n-type GaAs buffer layer 102 of approximately 200nm is grown on an n-type GaAs substrate 100 using an epitaxial deposition process known as metal-organic chemical vapor deposition ("MOCVD"). The doping level of the n-type GaAs substrate and GaAs buffer are typically around the range of 3 × 10¹⁸ cm⁻³ to 7 × 10¹⁸ cm⁻³ so that a reasonably low resistance can be achieved in these layers. The semiconductor layers may also be deposited on a substrate by liquid phase epitaxy ("LPE"), molecular beam epitaxy ("MBE"), or other known crystal growth processes.

A first reflector 104 is located on one side of an active layer 108 and a second reflector 114 is located on the opposite side of the active layer 108, whereby at least one of the reflectors 104, 114 allows a partial light transmission.

Above the GaAs buffer layer 102 is a superlattice structure for forming a lower distributed Bragg reflector ("DBR") 104 which provides a portion of the internal reflection in a VCSEL structure. The lower DBR 104 is typically formed by multiple pairs of an AlGaAs layer with a high aluminum content and another AlGaAs layer with a low aluminum content. After the growth of a number of layer pairs, a final AlGaAs layer with a high aluminum content is deposited before growing the first cladding layer 106 of the optical cavity. A typical thickness of each layer pair is approximately 120nm for a laser emitting at 820nm. The total thickness of each layer pair is designed to be equal to one half of the optical wavelength at the intended wavelength of laser operation. The thickness of the final high aluminum content layer is designed to be a quarter of the optical wavelength at the intended wavelength of laser operation. The AlGaAs layer with a high aluminum content contains approximately 86% aluminum. The aluminum content of the AlGaAs layer with a high aluminum content should be sufficiently high to provide for a low refractive index, but not so high as to oxidize easily. The AlGaAs layer with a low aluminum content has an aluminum content of approximately 16%. The composition of the AlGaAs layer with a low aluminum content should typically have sufficient aluminum so that it is non-absorptive at the lasing wavelength.

Under this embodiment, since light is outcoupled through the top surface of the semiconductor sample, the reflectivity of the lower DBR 104 should be as close to 100% as possible in order to achieve high internal reflection. High internal reflection generally reduces the threshold current of a laser. It is well-known that the reflectivity of the lower DBR 104 is generally a function of the difference in the refractive indices between the two AlGaAs layers of the superlattice and the number of layer pairs in the structure. The greater the difference in the refractive indices, the fewer number of pairs are required to obtain a given reflectivity. Typically, 30 to 40 pairs of AlGaAs layers are used to form the lower DBR structure 104.

After the lower DBR structure 104 has been deposited epitaxially, an AlGaAs cladding layer 106 is deposited. This lower AlGaAs cladding layer 106 has an aluminum content of about 58% and is n-type with a doping level of 1 × 10¹⁸ cm⁻³ to 5 × 10¹⁸ cm⁻³. Its thickness is approximately 100nm. Above this AlGaAs cladding layer 106 is the active layer 108 of the laser structure which comprises of four quantum wells with a thickness of five to ten nm, separated by three barriers with a thickness of two to eight nm. Depending upon the desired output wavelength of the laser structure, pure GaAs or AlGaAs with a low aluminum content may be used to form the quantum well structures. Under this embodiment, these quantum wells are typically formed by undoped AlGaAs with an aluminum content of approximately 7%. Nothing in this invention prevents the use of a single quantum well or other multiple quantum well ("MQW") structures to form the active layer 108.

Above the active layer 108 is an upper AlGaAs cladding layer 110, which is structurally similar to the lower AlGaAs cladding layer 106 except for the polarity of its dopants. This upper cladding layer 110 has an aluminum content of about 58% but is p-type with a doping level of 1 × 10¹⁸ cm⁻³ to 4 × 10¹⁸ cm⁻³. Similar to the lower AlGaAs cladding layer 106, the thickness of top cladding layer 110 is also about 100nm. These two AlGaAs cladding layers, 106 and 110, along with the active layer 108 generally form the optical cavity in which the desired optical gain can be attained. The total thickness of layers 106, 108, and 110 is adjusted to be equal to an integer multiple of the intended wavelength of laser operation.

Above the upper AlGaAs cladding layer 110 is an oxidation layer 112, which is used to form the laser aperture. The laser aperture controls the current flow and thus the lasing location in the active layer 108. Under this embodiment, this oxidation layer 112 is above the upper AlGaAs cladding layer 110. Nothing in this invention prevents the placement of this oxidation layer 112 in another location either further above or below the active layer 108. Typically, this oxidation layer 112 has an aluminum content of approximately 95% and a thickness of about 70nm. Typically, this oxidation layer 112 constitutes the first layer of an upper DBR mirror and contains a p-type dopant.

After the oxidation layer 112 has been formed, the remainder of an upper DBR mirror 114 which contains p-type doping is deposited. The upper DBR mirror 114 is structurally similar to the lower DBR mirror 104 except for the polarity of its dopants. Additionally, the mirror layer closest to each side of the active region generally has a high aluminum content. In this embodiment, this high aluminum content layer is also the oxidation layer 112. In this embodiment, the reflectivity of the upper DBR 114 is typically 98% to 99% because light will be outcoupled through the surface of the semiconductor sample. Typically, 20 to 25 pairs of alternate AlGaAs layers are used to form this upper DBR mirror 114.

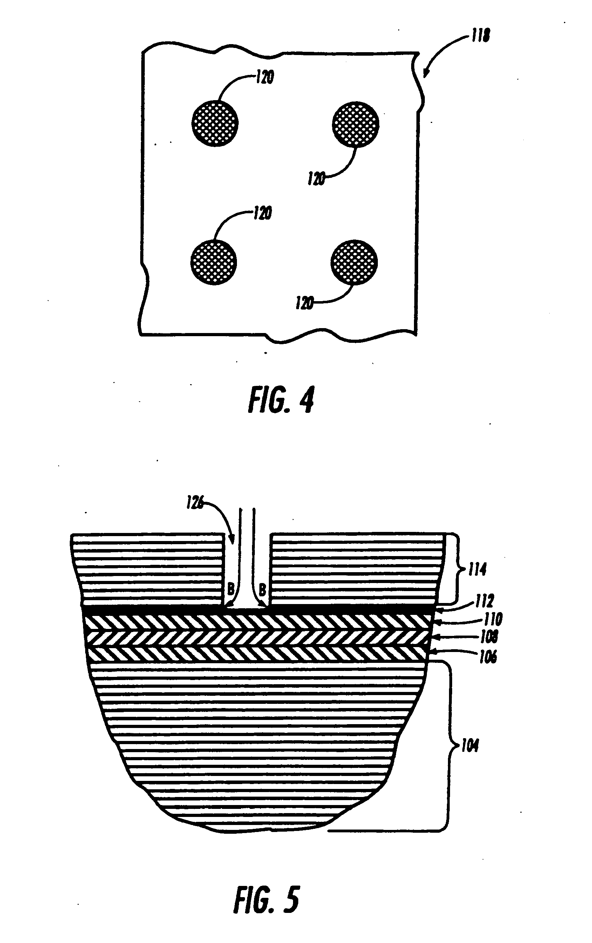

FIG. 4 is a top view of a portion of a mask which may be applied to the semiconductor structure shown in FIG. 3 in one embodiment. First, as is conventional, a uniform layer of silicon nitride will be deposited over the entire semiconductor sample. Then, a photoresist layer 118 is deposited over the silicon nitride layer and is formed into the mask shown in FIG. 4 by a photolithographic process which removes photoresist material from four circular areas 120. The circular areas 120 form a pre-determined bounding pattern which will later be used to define the resulting aperture of a laser structure.

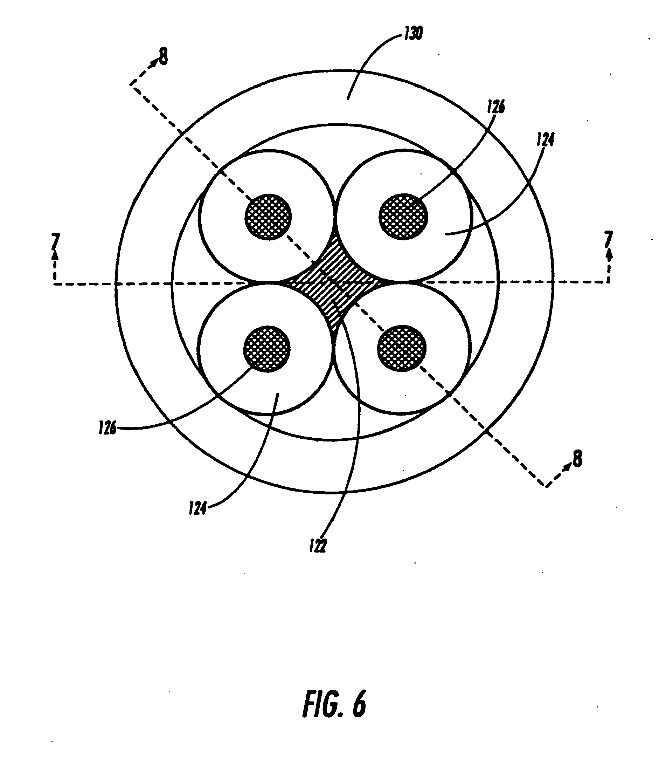

As illustrated in FIG. 5, the sample then undergoes an etching process during which cylindrical cavities 126 are formed in the semiconductor structure through the four exposed circular areas 120. The etching is performed by a process such as reactive ion etching which provides for the formation of a deep depression with vertical sidewalls. The depth of each cylindrical cavity should extend at least into the oxidation layer 112, as shown in FIG. 5. After the formation of the cylindrical cavities and the removal of any photoresist on the surface, the semiconductor sample undergoes an oxidation. The sample is typically oxidized with water vapor in a nitrogen environment at elevated temperatures, in excess of 350°C. During the oxidation process, the oxidation layer 112 is exposed to the ambient through each cylindrical cavity, as indicated by arrows B. Thus, the oxidation layer 112, which comprises of AlGaAs with a high aluminum content, is oxidized radially outwards from each cavity 126, typically until the oxidized regions 124 surrounding each cavity approach one another and overlap, as can be seen in FIG. 6. However, a small non-oxidized gap between the oxidized regions may be permissible so long as electrical and optical fields are adequately confined. Although the cross section of each cavity has been described as being cylindrical, any suitable cross section may be used.

During the oxidation process, other layers in the structure remain essentially unoxidized since their aluminum content is lower. The oxidation rate of AlGaAs increases with the aluminum content in a generally exponential manner at constant temperature. The time duration of the oxidation process depends upon the aluminum content in the oxidation layer 112 and the oxidation temperature. A desirable, controllable oxidation duration would be a few tens of minutes. Therefore, the layer that is being oxidized is the AlGaAs which has a high aluminum content of close to 95%. The portion of the AlGaAs layer which remains unoxidized controls the current path through the active layer 108.

FIG. 6 is a largely simplified top view of the oxidation layer 112 shown in FIG.3 assuming that all the layers above it have been removed. The shaded region 122 represents the laser aperture in oxidation layer 112 which determines the region of laser emission by active layer 108. It is formed by the oxidation process of the above embodiment. During the oxidation process, the oxidation fronts emanate through the oxidation layer from the pattern of four cavities 126, and the shaded region 122 is formed by the intersection of the boundaries of the oxidized regions 124. The oxidation fronts emanating from the cylindrical cavities 126 are also generally cylindrical, resulting in overlapping oxidized regions 124. The center of the overlapping regions 124 remains unoxidized. This unoxidized region forms the shaded area 122, which is the aperture of the laser structure. After the oxidation process, an ion implantation process, which is next described, is used to form isolation region 130 to isolate the laser structure from its neighbor.

After the oxidation process, the areas 124 are oxidized and the unoxidized portion 122 forms the aperture which controls the current path through the active layer 108. Current flow through that portion of the active layer 108 which lies below the aperture 122 results in an injected density of p-type and n-type carriers, resulting in optical amplification. At sufficiently high current flow, this optical amplification, in combination with feedback from the DBR mirrors, 104 and 114, will result in laser oscillation and emission from the active layer within the region defined by aperture 122 in oxidation layer 112.

Isolation region 130 (illustrated in FIGS. 6, 7 and 8), which is formed by using an ion implantation isolation process, is highly resistive. The typical implantation energies used in such a process are 50 KeV, 100 KeV, and 200 KeV. The dose is typically 3 x 10¹⁵ cm⁻² at each energy level. The ion used to form the isolation region 402 is hydrogen.

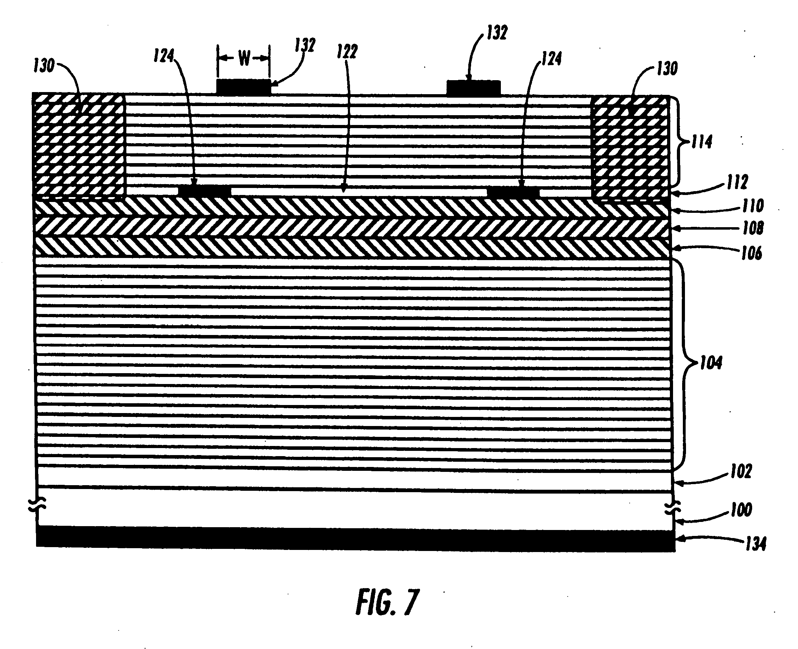

After the isolation process, metal contacts 132 and 134 are formed on the top surface and the bottom surface of the semiconductor structure, respectively, for biasing the laser, as illustrated in FIGS. 7,8 and 9. A typical material used for forming the contacts is a titanium/gold bilayer film.

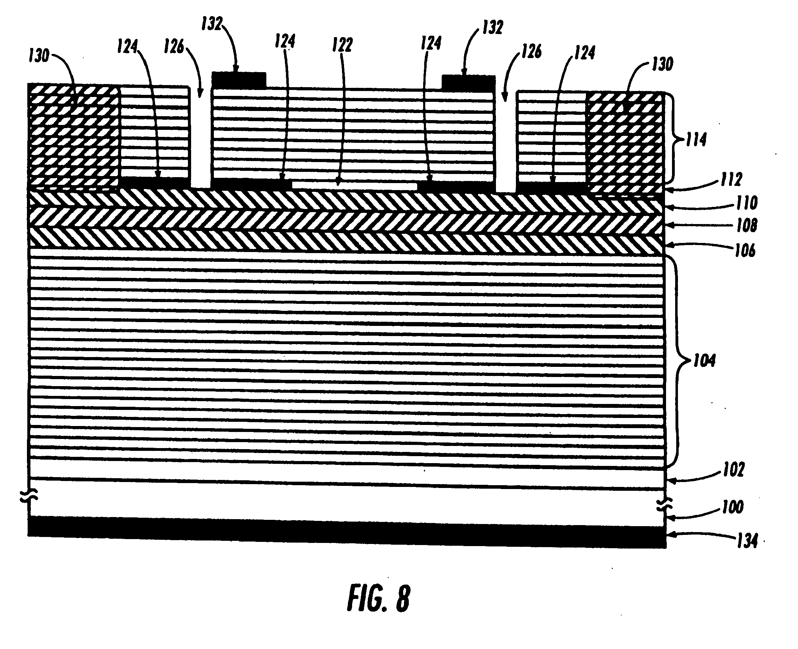

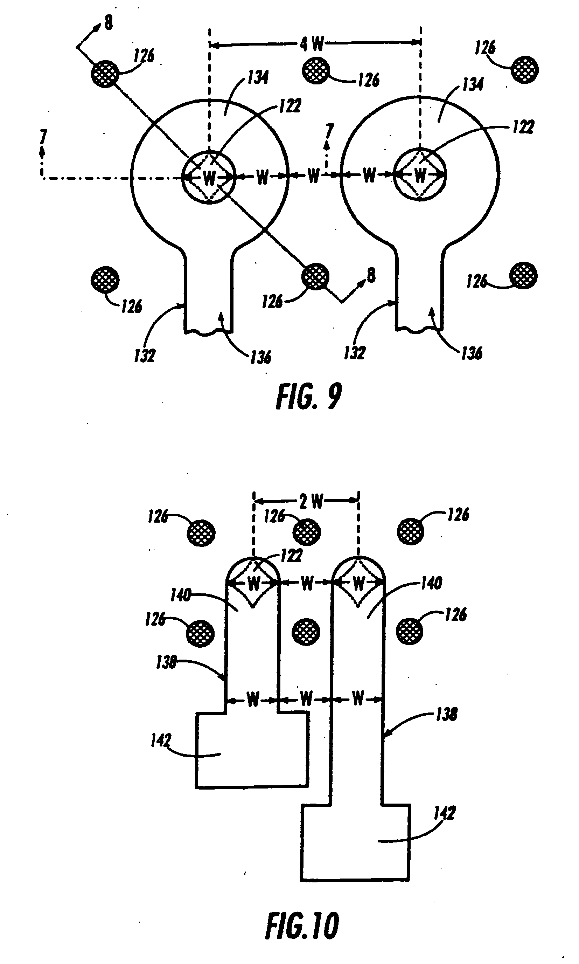

FIG. 9 shows a top view of a VCSEL structure formed in accordance to one embodiment after a typical metallization process to form the top contact 132. Views in the direction of section lines 7-7 and 8-8 in this Figure are also as illustrated in FIGS. 7 and 8. The top contact 132 is of a generally keyhole shape, including a circular portion 134 and an extension portion 136. The circular portion lies inboard of the cavities 126 and overlies the laser aperture 122. Since it is non-transparent it is made annular in shape so as to allow light to be coupled out of the laser through its central opening. The width "W" of the annular circular portion 134 is usually limited by the minimum line width achievable under the processing technology used, thus setting a lower limit on the pitch between adjacent VCSEL structures Thus, a typical pitch between the centers of two adjacent VCSEL apertures 122 would be "4W." However, if a transparent conductor is used, the pitch between adjacent VCSEL structures could be further reduced because the top contact could overlie the laser aperture 122. Thus, the pitch may be reduced to the order of "2W" as shown in FIG. 9. A typical transparent conductor is indium tin oxide ("ITO") which may be deposited by a sputtering process. An alternative embodiment of the top contact is shown in FIG. 10 and is identified by numeral 138. It comprises a transparent conductive contact finger 140 and contact pad 142, the contact finger overlying the laser aperture 122. After the formation of an electrical contact on the top surface, the bottom electrode 134 is formed by depositing metal on the bottom surface of the substrate 100.

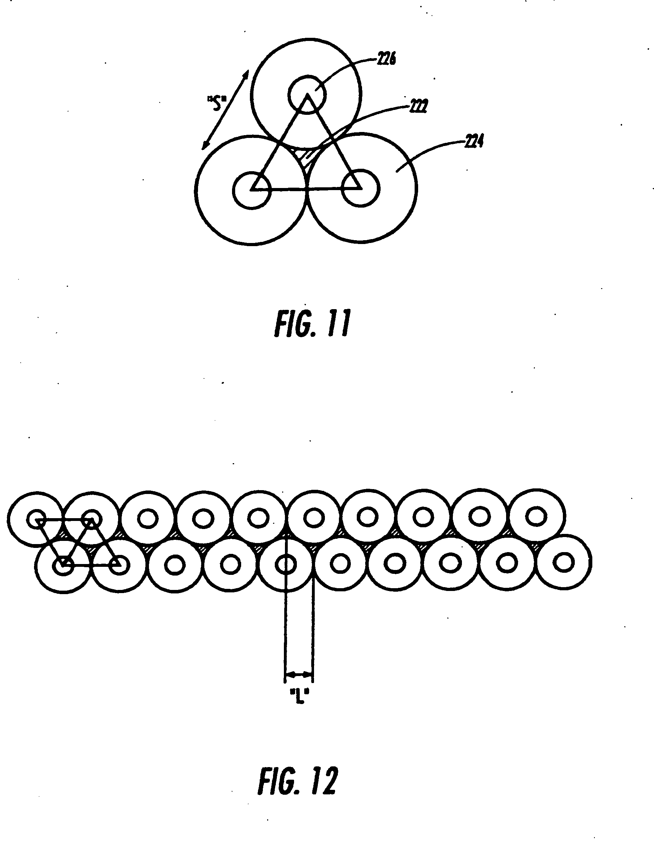

FIGS. 11, and 12, 13, 14 and 15, and 16, 17 and 18 illustrate alternative packing arrangements for forming an array of lasers formed by other embodiments. In the laser device of FIG. 11 and an array of such devices shown in FIG. 12, each laser structure includes an aperture 222 defined by oxidized regions 224 surrounding a bounding pattern of three cylindrical cavities 226 positioned at the apexes of an equilateral triangle. The spacing between the centers of any two neighboring cavities is "S." As stated previously, during the oxidation process, an embedded AlGaAs layer with a high aluminum content will be oxidized radially outwardly from the cylindrical cavities 226 until the oxidized regions 224 overlap to form the unoxidized laser aperture 222. The packing arrangement shown in FIG. 11 may be repeated to form a laser array as shown in FIG. 12. If the spacing between the centers of two cylindrical cavities is "S," a typical linear spacing "L" between two laser apertures is approximately "S/2."

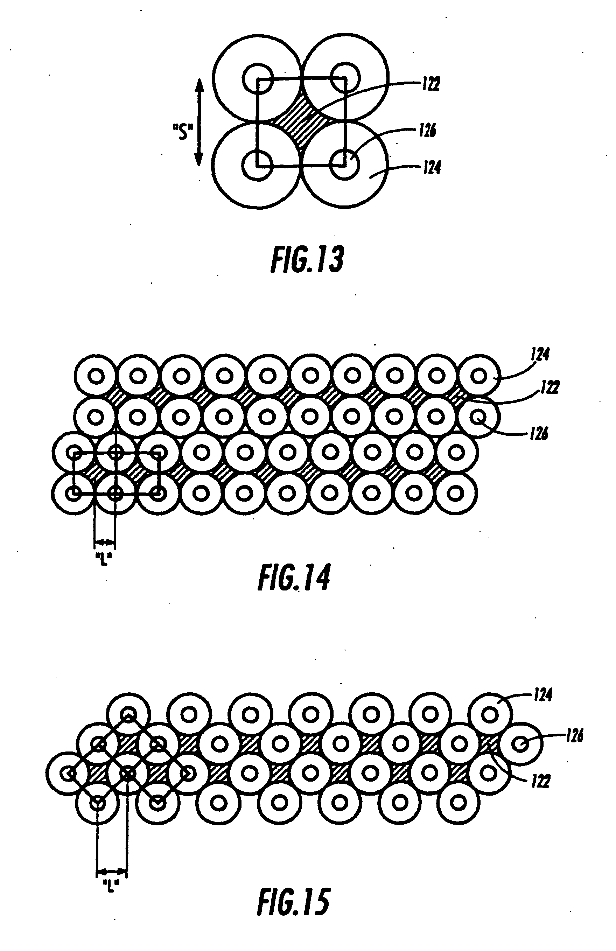

In the laser device of FIG. 13 and the arrays of FIGS. 14 and 15, the square bounding pattern of cylindrical cavities 126 is illustrated. Oxidized regions 124 will overlap to form the unoxidized laser aperture 122. This packing arrangement shown in FIG. 13 may be repeated to form a laser array as shown in FIGS. 14 or 15 If a packing arrangement such as FIG. 14 is used and the spacing between the centers of two adjacent cylindrical cavities is "S," a typical linear spacing "L" between two laser apertures is approximately "S/2." If an arrangement such as FIG. 15 is used and the spacing between the centers of two cylindrical depressions is "S," a typical linear spacing "L" between two laser apertures is approximately "√2 × S."

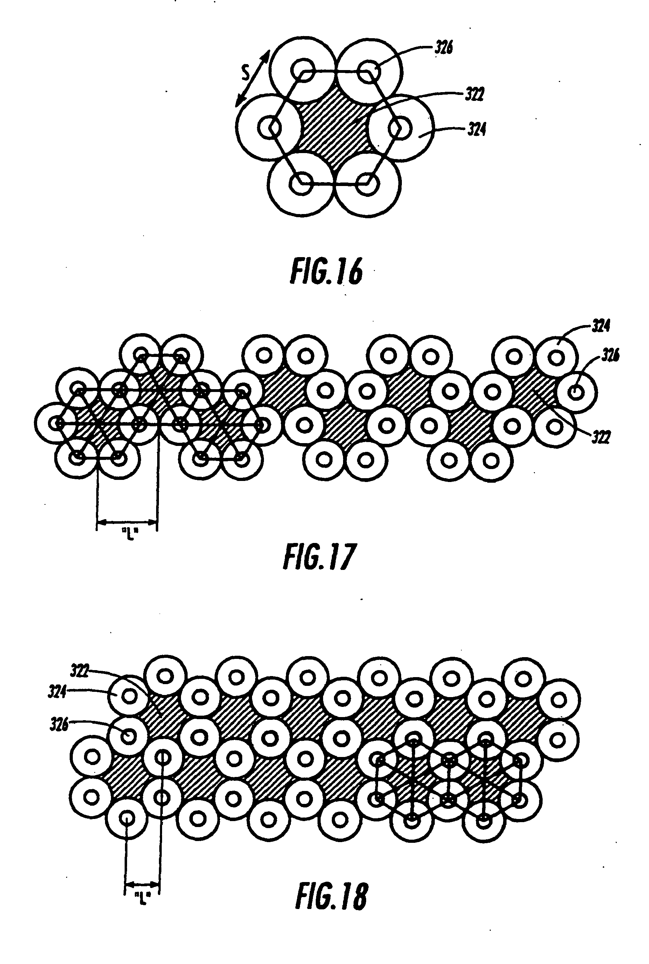

In the laser device of FIG. 16 and the arrays of FIGS. 17 and 18, an hexagonal bounding pattern of cylindrical cavities is illustrated It should be apparent that the cavities 326 may also be arranged at the vertices of any other polygon. As in the previously described embodiments, the laser aperture is formed by the unoxidized region 322 defined by the oxidized regions 324. The packing arrangement shown in FIG. 16 may be repeated to form a laser array as shown in FIGS. 17 or 18. If an arrangement such as FIG. 17 is used and the spacing between the centers of two adjacent cylindrical cavities is "S," a typical linear spacing "L" between two laser apertures is approximately "1.5S." If an arrangement such as FIG. 18 is used, the closest linear spacing "L" between two laser apertures is approximately "√3 × 0.5S."

The composition, dopants, doping levels, and dimensions given above are exemplary only, and variations in these parameters are permissible. Additionally, other layers in addition to the ones shown in the figures may also be included. Variations in experimental conditions such as temperature and time are also permitted. Lastly, instead of GaAs and GaAlAs, other semiconductor materials such as GaAlSb, InAlGaP, or other III-V alloys may also be used.

Embodiments have been described in which non-conductive regions meet or slightly overlap. As noted above, however, non-oxidized gaps could occur between non-conductive regions. All that is necessary is that the non-conductive regions substantially bound a conductive region so that electrical and optical fields are adequately confined that the conductive region can serve as a laser cavity.

## Claims

1. A surface emitting laser having a light emitting surface, said laser comprising:
a substrate (100);
a plurality of semiconductor layers formed on said substrate (100);
one of said semiconductor layers comprising an active layer (108) having an active region therein;
one of said semiconductor layers being a current controlling layer (112) **characterized in that** said current controlling layer (112) is penetrated by a plurality of non-conducting cavities (126, 226, 326) arranged in a bounding pattern around an aperture region (122, 222, 322) in said current controlling layer (112), said aperture region (122, 222, 322) being defined by a conductive region (122, 222, 322) in said current controlling layer (112) bordered by non-conductive regions (124, 224, 324) in said current controlling layer (112), each of the non-conductive regions (124, 224, 324) surrounds at least one of said plurality of non-conducting cavities (126, 226, 326); and said aperture region (122, 222, 322) has a shape and a size that are dependent upon the shape and arrangement of said non-conducting cavities (126, 226, 326).

2. The surface emitting laser of claim 1 wherein said current controlling layer (112) is an oxidation layer (112), said conductive region (122, 222, 322) is an unoxidized portion (122, 222, 322) of said oxidation layer (112), and said non-conductive regions (124, 224, 324) are oxidized portions (124, 224, 324) of said oxidation layer (112).

3. The surface emitting laser of claim 2 wherein said oxidation layer (112) comprises an aluminum containing semiconductor layer.

4. The surface emitting laser of claim 1 further comprising:
first (132, 138) and second (134) electrodes located on said laser device to enable biasing of said active region.

5. The surface emitting laser of claim 4 wherein said first electrode (132, 138) is located on said emitting surface and overlies said aperture region (122, 222, 322).

6. The surface emitting laser of claim 5 wherein said first electrode (132, 138) is non-transparent and includes an opening therein through which light energy may be transmitted out of the laser.

7. The surface emitting laser of claim 5 wherein said first electrode is transparent and allows a partial transmission of light energy therethrough.

8. The surface emitting laser of claim 1 wherein said plurality of semiconductor layers comprises a Group III-V arsenide material.

9. The surface emitting laser of claim 1 wherein said plurality of non-conducting cavities (226) are disposed in an equilateral triangular bounding pattern.

10. The surface emitting laser of claim 1 wherein said plurality of non-conducting cavities (126) are disposed in a square bounding pattern.

11. The surface emitting laser of claim 1 wherein said plurality of non-conducting cavities (326) are disposed in a regular hexagonal bounding pattern.

12. An array of surface emitting lasers, wherein each of said surface emitting lasers comprises a device in accordance with claim 1.

13. The surface emitting laser having a light emitting surface according to claim 1 wherein said laser comprises a single aperture region (122, 222, 322).

14. The surface emitting laser having a light emitting surface according to claim 1 wherein said laser comprises more than one aperture region (122, 222, 322).

15. The surface emitting laser having a light emitting surface according to claim 1, wherein said non-conducting cavities (126, 226, 326) are cylindrical hollows.

16. The surface emitting laser having a light emitting surface according to claim 15, wherein each of said hollow cavities (126, 226, 326) contains a center point, and wherein said hollow cavities (126, 226, 326) are arranged in a polygonal pattern such that the center point of each of said hollow cavities (126, 226, 326) represents one corner of at least one polygon containing an aperture region (122, 222, 322).

17. The surface emitting laser having a light emitting surface according to
claim 1 wherein said oxidized portions (124, 224, 324) bounding said aperture region (122, 222, 322) are contiguous.

18. The surface emitting laser having a light emitting surface according to claim 1 wherein said aperture region (122, 222, 322) is defined by a continuous boundary formed by said oxidized portions (124, 224, 324) surrounding said hollow cavities (126, 226, 326) in said current controlling layer (112).

19. A method of producing a surface emitting laser having a light emitting surface, said method comprising the steps of:
providing a substrate (100);
forming a plurality of semiconductor layers on said substrate (100);
providing in one of said semiconductor layers an active layer (108) having an active region therein;
providing in one of said semiconductor layers a current controlling layer (112), whereby said current controlling layer (112) is penetrated by a plurality of hollow cavities (126, 226, 326);
providing an aperture region (122, 222, 322) in said current controlling layer (112) which affects current flowing through said active region,
said aperture region (122, 222, 322) being formed by the steps of:
bordering said current controlling layer (112) by oxidized portions (124, 224, 324) in said current controlling layer (112) in a bounding pattern,
providing a conductive region (122, 222, 322) in said current controlling layer (112),
applying oxidizing conditions via said hollow cavities (126, 226, 326) and thereby oxidizing said current controlling layer (112) outwards from said hollow cavities (126, 226, 326) to form said oxidized portions (124, 224, 324) surrounding said hollow cavities (126, 226, 326), and ceasing to apply said oxidizing conditions and thereby (a) terminating said oxidizing and (b) controlling and establishing size and shape of said aperture region (122, 222, 322).

20. The method according to claim 19 wherein said method comprises forming a single aperture region (122, 222, 322).

21. The method according to claim 19 wherein said method comprises forming more than one aperture region (122, 222, 322).

22. The method according to claim 19 wherein said hollow cavities (126, 226, 326) are cylindrical.

23. The method according to claim 19 wherein said hollow cavities (126, 226, 326) are arranged in a polygonal pattern such that a center point of each of said hollow cavities (126, 226, 326) represents one corner of at least one polygon containing an aperture region (122, 222, 322).

24. The method according to claim 19 wherein said oxidized regions bordering said aperture region (122, 222, 322) are contiguous.

25. The method according to claim 19 wherein said aperture region (122, 222, 322) is defined by a continuous boundary formed by said oxidized portions (124, 224, 324) surrounding said hollow cavities (126, 226, 326) in said current controlling layer (112).

26. The method according to claim 19 further comprising the step of forming at least one non-oxidized gap between said oxidized portions (124, 224, 324).

27. The method according to claim 19 further comprising the step of:
providing a first reflector (114) located on one side of said active layer (108) and a second reflector (104) located on an opposite side of said active layer (108), at least one of said reflectors (104, 114) allowing a partial transmission of light energy therethrough.

28. The method according to claim 19 further comprising the step of:
providing first (132, 138) and second (134) electrodes located on said laser device to enable biasing of said active region, said aperture formed by providing said hollow cavities (126, 226, 326) in a predetermined pattern to determine the size and shape of the aperture region (122, 222, 322).

29. The method according to claim 19 further comprising the step of:
forming an isolation region (130) by using an ion implantation isolation process.

30. The method according to claim 29 wherein the implantation energies used in such a process are in a range between 50 KeV and 200 KeV.

31. The method according to claim 29 or 30 wherein the dose is typically 3 x 10¹⁵ cm⁻² at each energy level.

32. The method according to claim 29, 30 or 31 wherein the ion used to form the isolation region (130) is hydrogen.

## Patentansprüche

1. Oberflächenemittierender Laser mit einer lichtemittierenden Oberfläche, wobei der Laser umfasst:
ein Substrat (100);
eine Vielzahl von Halbleiterschichten, die auf dem Substrat (100) ausgebildet sind;
wobei eine der Halbleiterschichten eine aktive Schicht (108) mit einem aktiven Bereich darin umfasst;
wobei eine der Halbleiterschichten eine Stromsteuerschicht (112) ist,
**dadurch gekennzeichnet, dass**
die Stromsteuerschicht (112) von einer Vielzahl von nichtleitenden Hohlräumen (126, 226, 326) durchdrungen ist, die in einem zusammenhängenden Muster um einen Aperturbereich (122, 222, 322) in der Stromsteuerschicht (112) angeordnet sind, wobei der Aperturbereich (122, 222, 322) durch einen leitfähigen Bereich (122, 222, 322) in der Stromsteuerschicht (112) definiert ist, der durch nichtleitfähige Bereiche (124, 224, 324) in der Stromsteuerschicht (112) begrenzt wird, wobei jeder der nichtleitfähigen Bereiche (124, 224, 324) zumindest einen der Vielzahl von nichtleitenden Hohlräumen (126, 226, 326) umgibt; und wobei der Aperturbereich (122, 222, 322) eine Form und eine Größe aufweist, die von der Form und Anordnung der nichtleitenden Hohlräume (126, 226, 326) abhängen.

2. Oberflächenemittierender Laser nach Anspruch 1, worin die Stromsteuerschicht (112) eine Oxidationsschicht (112) ist, wobei der leitfähige Bereich (122, 222, 322) ein nichtoxidierter Bereich (122, 222, 322) der Oxidationsschicht (112) ist, und die nichtleitfähigen Bereiche (124, 224, 324) oxidierte Bereiche (124, 224, 324) der Oxidationsschicht (112) sind.

3. Oberflächenemittierender Laser nach Anspruch 2, worin die Oxidationsschicht (112) eine Aluminium enthaltende Halbleiterschicht umfasst.

4. Oberflächenemittierender Laser nach Anspruch 1, der Weiterhin umfasst:
erste (132, 138) und zweite (134) Elektroden, die auf der Laservorrichtung liegen, um ein Vorspannen des aktiven Bereichs zu ermöglichen.

5. Oberflächenemittierender Laser nach Anspruch 4, worin die erste Elektrode (132, 138) auf der emittierenden Oberfläche und über dem Aperturbereich (122, 222, 322) liegt.

6. Oberflächenemittierender Laser nach Anspruch 5, worin die erste Elektrode (132, 138) nicht transparent ist und eine Öffnung darin einschließt, die Lichtenergie aus dem Laser durchlassen kann.

7. Oberflächenemittierender Laser nach Anspruch 5, worin die erste Elektrode durchsichtig ist und eine teilweise Transmission von Lichtenergie **dadurch** erlaubt.

8. Oberflächenemittierender Laser nach Anspruch 1, worin die Vielzahl von Halbleiterschichten ein Gruppe III-V-Arsenidmaterial umfasst.

9. Oberflächenemittierender Laser nach Anspruch 1, worin die Vielzahl von nichtleitenden Hohlräumen (226) in einem zusammenhängenden Muster aus gleichschenkligen Dreiecken angeordnet sind.

10. Oberflächenemittierender Laser nach Anspruch 1, worin die Vielzahl von nichtleitfähigen Hohlräumen (126) in einem zusammenhängenden Muster aus Quadraten angeordnet sind.

11. Oberflächenemittierender Laser nach Anspruch 1, worin die Vielzahl von nichtleitfähigen Hohlräumen (326) in einem zusammenhängenden Muster aus regelmäßigen Hexagonen angeordnet sind.

12. Array aus oberflächenemittierenden Lasern, worin jeder der oberflächenemittierenden Laser eine Vorrichtung nach Anspruch 1 umfasst.

13. Oberflächenemittierender Laser mit einer lichtemittierenden Oberfläche nach Anspruch 1, worin der Laser einen einzelnen Aperturbereich (122, 222, 322) umfasst.

14. Oberflächenemittierender Laser mit einer lichtemittierenden Oberfläche nach Anspruch 1, worin der Laser mehr als einen Aperturbereich (122, 222, 322) umfasst.

15. Oberflächenemittierender Laser mit einer lichtemittierenden Oberfläche nach Anspruch 1, worin die nichtleitenden Hohlräume (126, 226, 326) zylinderförmige Aussparungen sind.

16. Oberflächenemittierender Laser mit einer lichtemittierenden Oberfläche nach Anspruch 15, worin jeder der ausgesparten Hohlräume (126, 226, 326) einen Mittelpunkt enthält, und worin die ausgesparten Hohlräume (126, 226, 326) in einem Polygonmuster angeordnet sind, so dass der Mittelpunkt jedes der ausgesparten Hohlräume (126, 226, 326) eine Ecke mindestens eines Polygons repräsentiert, der einen Aperturbereich (122, 222, 322) enthält.

17. Oberflächenemittierender Laser mit einer lichtemittierenden Oberfläche nach Anspruch 1, worin die oxidierten Bereiche (124, 224, 324), die den Aperturbereich (122, 222, 322) bilden, zusammenhängen.

18. Oberflächenemittierender Laser mit einer lichtemittierenden Oberfläche nach Anspruch 1, worin der Aperturbereich (122, 222, 322) durch eine kontinuierliche Grenze definiert wird, die durch die oxidierten Bereiche (124, 224, 324) gebildet wird, die die ausgesparten Hohlräume (126, 226, 326) in der Stromsteuerschicht (112) umgibt.

19. Verfahren zur Herstellung eines oberflächenemittierenden Lasers mit einer lichtemittierenden Oberfläche, wobei das Verfahren folgende Schritte umfasst:
Bereitstellen eines Substrats (100);
Bilden einer Vielzahl von Halbleiterschichten auf dem Substrat (100);
Bereitstellen einer aktiven Schicht (108) mit einem aktiven Bereich darin in einem der Halbleiterschichten;
Bereitstellen einer Stromsteuerschicht (112) in einem der Halbleiterschichten, wobei die Stromsteuerschicht (112) von einer Vielzahl von ausgenommenen Hohlräumen (126, 226, 326) durchdrungen ist;
Bereitstellen eines Aperturbereiches (122, 224, 322) in der Stromsteuerschicht (112), welcher den Strom beeinflusst, der durch die aktive Schicht fließt,
wobei der Aperturbereich (122, 222, 322) durch folgende Schritte gebildet wird:
Abgrenzen der Stromsteuerschicht (112) durch oxidierte Bereiche (124, 224, 324) in der Stromsteuerschicht (112) in einem zusammenhängenden Muster,
Bereitstellen eines leitfähigen Bereichs (122, 222, 322) in der Stromsteuerschicht (112), Anwenden von Oxidationsbedingungen auf die ausgenommenen Hohlräume (126, 226, 326) und dabei Oxidieren der Stromsteuerschicht (112) nach außen von den ausgenommenen Hohlräumen (126, 226, 326), um die oxidierten Bereiche (124, 224, 324) zu bilden, die die ausgenommenen Hohlräume (126, 226, 326) umgeben, und
Beenden der Anwendung der Oxidationsbedingungen und dabei (a) Beenden des Oxidierens und (b) Steuern und Festlegen von Größe und Form des Aperturbereichs (122, 222, 322).

20. Verfahren nach Anspruch 19, worin das Verfahren das Bilden eines einzelnen Aperturbereiches (122, 222, 322) umfasst.

21. Verfahren nach Anspruch 19, worin das Verfahren das Bilden von mehr als einem Aperturbereich (122, 222, 322) umfasst.

22. Verfahren nach Anspruch 19, worin die ausgenommenen Hohlräume (126, 226, 326) zylindrisch sind.

23. Verfahren nach Anspruch 19, worin die ausgenommenen Hohlräume (126, 226, 326) in einem Polygonmuster angeordnet sind, so dass ein Mittelpunkt von jedem der ausgenommenen Hohlräume (126, 226, 326) eine Ecke mindestens eines Polygons repräsentiert, das einen Aperturbereich (122, 222, 322) enthält.

24. Verfahren nach Anspruch 19, worin die oxidierten Bereiche, die den Aperturbereich (122, 222, 322) abgrenzen, zusammenhängen.

25. Verfahren nach Anspruch 19, worin der Aperturbereich (122, 222, 322) durch eine kontinuierliche Grenze definiert wird, die durch die oxidierten Bereiche (124, 224, 324) gebildet wird, die die ausgenommenen Hohlräume (126, 226, 326) in der Stromsteuerschicht (112) umgeben.

26. Verfahren nach Anspruch 19, das weiterhin den Schritt des Bildens mindestens einer nichtoxidierten Lücke zwischen den oxidierten Bereichen (124, 224, 324) umfasst.

27. Verfahren nach Anspruch 19, das weiterhin folgenden Schritt umfasst:
Bereitstellen eines ersten Reflektors (114), der auf einer Seite der aktiven Schicht (108) liegt, und eines zweiten Reflektors, der auf einer gegenüberliegenden Seite der aktiven Schicht (108) liegt, wobei mindestens einer der Reflektoren (104, 114) ein teilweises Durchlassen von Lichtenergie **dadurch** erlaubt.

28. Verfahren nach Anspruch 19, das weiterhin den folgenden Schritt umfasst:
Bereitstellen von ersten (132, 138) und zweiten (134) Elektroden, die auf der Laservorrichtung liegen, um ein Vorspannen des aktiven Bereiches zu ermöglichen, wobei die Apertur gebildet wird, indem die ausgenommenen Hohlräume (126, 226, 326) in einem vorbestimmten Muster bereitgestellt werden, um die Größe und die Form des Aperturbereichs (122, 222, 322) zu bestimmen.

29. Verfahren nach Anspruch 19, das weiteren folgenden Schritt umfasst:
Bilden eines Isolationsbereichs (130) durch Verwendung eines lonenimplantationsisolationsprozesses.

30. Verfahren nach Anspruch 29, worin die Implantationsenergien, die in einem solchen Prozess verwendet werden, in einem Bereich zwischen 50 KeV und 200 KeV liegen.

31. Verfahren nach Anspruch 29 oder 30, worin die Dosis typischerweise 3 x 10¹⁵ cm⁻² in jedem Energieniveau ist.

32. Verfahren nach Anspruch 29, 30 oder 31, worin das Ion, das verwendet wird, um den Isolationsbereich (130) zu bilden, Wasserstoff ist.

## Revendications

1. Laser à émission par la surface ayant une surface émettant de la lumière, ledit laser comprenant :
un substrat (100) ;
une pluralité de couches semi-conductrices formées sur ledit substrat (100) ;
l'une desdites couches semi-conductrices comprenant une couche active (108) à l'intérieur de laquelle se trouve une région active ;
l'une desdites couches semi-conductrices étant une couche de commande de courant (112) **caractérisé en ce qu'**une pluralité de cavités non-conductrices (126, 226, 326) agencées selon un motif englobant autour d'une région d'ouverture (122, 222, 322) dans ladite couche de commande du courant (112) pénètrent dans ladite couche de commande du courant (112), ladite région d'ouverture (122, 222, 322) étant définie par une région conductrice (122, 222, 322) dans ladite couche de commande du courant (112) bordée par des régions non-conductrices (124, 224, 324) dans ladite couche de commande du courant (112), chacune des régions non-conductrices (124, 224, 324) entoure au moins l'une de ladite pluralité de cavités non-conductrices (126, 226, 326) ; et ladite région d'ouverture (122, 222, 322) a une forme et une taille qui dépendent de la forme et de la disposition desdites cavités non-conductrices (126, 226, 326).

2. Laser à émission par la surface de la revendication 1 dans lequel ladite couche de commande de courant (112) est une couche d'oxydation (112), ladite région conductrice (122, 222, 322) est une partie non oxydée (122, 222, 322) de ladite couche d'oxydation (112), et lesdites régions non-conductrices (124, 224, 324) sont des parties oxydées (124, 224, 324) de ladite couche d'oxydation (112).

3. Laser à émission par la surface de la revendication 2 dans lequel ladite couche d'oxydation (112) comprend une couche semi-conductrice contenant de l'aluminium.

4. Laser à émission par la surface de la revendication 1 comprenant en outre :
des première (132, 138) et deuxième (134) électrodes situées sur ledit dispositif laser pour permettre la polarisation de ladite région active.

5. Laser à émission par la surface de la revendication 4 dans lequel ladite première électrode (132, 138) est située sur ladite surface émettrice et recouvre ladite région d'ouverture (122, 222, 322).

6. Laser à émission par la surface de la revendication 5 dans lequel ladite première électrode (132, 138) n'est pas transparente et comporte à l'intérieur une ouverture à travers laquelle de l'énergie lumineuse peut être transmise hors du laser.

7. Laser à émission par la surface de la revendication 5 dans lequel ladite première électrode est transparente et à travers laquelle une transmission partielle de l'énergie lumineuse est possible.

8. Laser à émission par la surface de la revendication 1 dans lequel ladite pluralité de couches semi-conductrices comprend un matériau d'arséniure du groupe III-V.

9. Laser à émission par la surface de la revendication 1 dans lequel ladite pluralité de cavités non-conductrices (226) est disposée selon un motif englobant triangulaire équilatéral.

10. Laser à émission par la surface de la revendication 1 dans lequel ladite pluralité de cavités non-conductrices (126) est disposée selon un motif englobant carré.

11. Laser à émission par la surface de la revendication 1 dans lequel ladite pluralité de cavités non conductrices (326) est disposée selon un motif englobant hexagonal régulier.

12. Réseau de lasers d'émission par la surface, dans lequel chacun desdits lasers d'émission par la surface comprend un dispositif selon la revendication 1.

13. Laser à émission par la surface ayant une surface émettant de la lumière selon la revendication 1 dans lequel ledit laser comprend une seule région d'ouverture (122, 222, 322).

14. Laser à émission par la surface ayant une surface émettant de la lumière selon la revendication 1 dans lequel ledit laser comprend plus d'une région d'ouverture (122, 222, 322).

15. Laser à émission par la surface ayant une surface émettant de la lumière selon la revendication 1, dans lequel lesdites cavités non-conductrices (126, 226, 326) sont des creux cylindriques.

16. Laser à émission par la surface ayant une surface émettant de la lumière selon la revendication 15, dans lequel chacune desdites cavités creuses (126, 226, 326) contient un point central, et dans lequel lesdites cavités creuses (126, 226, 326) sont agencées selon un modèle polygonal de sorte que le point central de chacune desdites cavités creuses (126, 226, 326) représente un coin d'au moins un polygone contenant une région d'ouverture (122, 222, 322).

17. Laser à émission par la surface ayant une surface émettant de la lumière selon la revendication 1, dans lequel lesdites parties oxydées (124, 224, 324) bordant ladite région d'ouverture (122, 222, 322) sont contigües.

18. Laser à émission par la surface ayant une surface émettant de la lumière selon la revendication 1, dans lequel ladite région d'ouverture (122, 222, 322) est définie par une frontière continue formée par lesdites parties oxydées (124, 224, 324) entourant lesdites cavités creuses (126, 226, 326) dans ladite couche de commande du courant (112).

19. Procédé de production d'un laser à émission par la surface ayant une surface émettant de la lumière, ledit procédé comprenant les étapes qui consistent :
à fournir un substrat (100) ;
à former une pluralité de couches semi-conductrices sur ledit substrat (100) ;
à fournir dans l'une des couches semi-conductrices une couche active (108) dans laquelle se trouve une région active ;
à fournir dans l'une desdites couches semi-conductrices une couche de commande du courant (112), moyen par lequel une pluralité de cavités creuses (126, 226, 326) pénètrent dans ladite couche de commande du courant (112) ;
à fournir une région d'ouverture (122, 222, 322) dans ladite couche de commande du courant (112) qui affecte le courant circulant dans ladite région active,
ladite région d'ouverture (122, 222, 322) étant formée par les étapes qui consistent :
à border ladite couche de commande du courant (112) par des parties oxydées (124, 224, 324) dans ladite couche de commande du courant (112) selon un motif englobant,
à fournir une région conductrice (122, 222, 322) dans ladite couche de commande du courant (112),
à appliquer des conditions d'oxydation à travers lesdites cavités creuses (126, 226, 326) et à oxyder ainsi ladite couche de commande du courant (112) vers l'extérieur à partir desdites cavités creuses (126, 226, 326) pour former lesdites parties oxydées (124, 224, 324) entourant lesdits cavités creuses (126, 226, 326), et
à cesser d'appliquer lesdits conditions d'oxydation et (a) à mettre fin ainsi à ladite oxydation et (b) à commander et à établir la taille et la forme de ladite région d'ouverture (122, 222, 322).

20. Procédé selon la revendication 19 dans lequel ledit procédé comprend le fait de former une seule région d'ouverture (122, 222, 322).

21. Procédé selon la revendication 19 dans lequel ledit procédé comprend le fait de former plus d'une région d'ouverture (122, 222, 322).

22. Procédé selon la revendication 19 dans lequel lesdites cavités creuses (126, 226, 326) sont cylindriques.

23. Procédé selon la revendication 19 dans lequel lesdites cavités creuses (126, 226, 326) sont agencées selon un motif polygonal de sorte qu'un point central de chacune desdites cavités creuses (126, 226, 326) représente un coin d'au moins un polygone contenant une région d'ouverture (122, 222, 322).

24. Procédé selon la revendication 19 dans lequel lesdites régions oxydées bordant ladite région d'ouverture (122, 222, 322) sont contigües.

25. Procédé selon la revendication 19 dans lequel ladite région d'ouverture (122, 222, 322) est définie par une frontière continue formée par lesdites parties oxydées (124, 224, 324) entourant lesdites cavités creuses (126, 226, 326) dans ladite couche de commande du courant (112).

26. Procédé selon la revendication 19 comprenant en outre l'étape qui consiste à former au moins un espace non oxydé entre lesdites parties oxydées (124, 224, 324).

27. Procédé selon la revendication 19 comprenant en outre l'étape qui consiste :
à fournir un premier réflecteur (114) situé sur un côté de ladite couche active (108) et un deuxième réflecteur (104) situé sur un côté opposé de ladite couche active (108), au moins l'un desdits réflecteurs (104, 114) permettant une transmission partielle de l'énergie lumineuse le traversant.

28. Procédé selon la revendication 19 comprenant en outre l'étape qui consiste :
à fournir les première (132, 138) et deuxième (134) électrodes situées sur ledit dispositif laser pour permettre la polarisation de ladite région active, ladite ouverture formée en fournissant lesdites cavités creuses (126, 226, 326) selon un motif prédéterminé afin de déterminer la taille et la forme de la région d'ouverture (122, 222, 322).

29. Procédé selon la revendication 19 comprenant en outre l'étape qui consiste : à former une région d'isolation (130) en utilisant un processus d'isolement à implantation ionique.

30. Procédé selon la revendication 29 dans lequel les énergies d'implantation utilisées dans un tel processus sont dans une plage entre 50 keV et 200 keV.

31. Procédé selon la revendication 29 ou 30 dans lequel la dose est typiquement de 3 x 10¹⁵ cm⁻² à chaque niveau d'énergie.

32. Procédé selon la revendication 29, 30 ou 31 dans lequel l'ion utilisé pour former la région d'isolation (130) est de l'hydrogène.
